# EUROPÄISCHE PATENTSCHRIFT

(11) **EP 1 230 679 B1**
(45) Veröffentlichungstag und Bekanntmachung des Hinweises auf die Patenterteilung: **20.07.2005**
(21) Anmeldenummer: 00988572.4
(22) Anmeldetag: 10.11.2000
(51) Int. Cl.: H01L 23/498, H01L 21/48

(54) **VERFAHREN ZUR HERSTELLUNG EINES TRÄGERELEMENTES FÜR EINEN IC-BAUSTEIN**
METHOD FOR PRODUCING A SUPPORT ELEMENT FOR AN INTEGRATED CIRCUIT (IC) COMPONENT
PROCEDE POUR PRODUIRE UN ELEMENT SUPPORT DESTINE A UN MODULE A CIRCUIT INTEGRE

(30) Priorität: 18.11.1999 DE 19955537
(43) Veröffentlichungstag der Anmeldung: 14.08.2002
(73) Patentinhaber: Orga Kartensysteme GmbH, 33104 Paderborn (DE)
(72) Erfinder: SENGE, Carsten, 24105 Kiel (DE); STAUDT, Mathias, 24113 Kiel (DE); MENTZER, Rüdiger, 24783 Osterrönfeld (DE)
(86) Internationale Anmeldenummer: PCT/DE2000/003930
(87) Internationale Veröffentlichungsnummer: WO 2001/037621

(56) Entgegenhaltungen:
- EP-A- 0 529 097
- DE-A- 19 502 157
- US-A- 5 200 362
- US-A- 5 877 042
- PATENT ABSTRACTS OF JAPAN vol. 011, no. 367 (E-561), 28. November 1987 (1987-11-28) & JP 62 139348 A (FURUKAWA ELECTRIC CO LTD:THE), 23. Juni 1987 (1987-06-23)

## Beschreibung

Die Erfindung betrifft ein Verfahren zur Herstellung eines Trägerelementes für einen zum Einbau in eine Datenträgerkarte vorgesehenen IC-Baustein, bei dem aus einer leitenden Schicht Leiterbahnen geätzt werden, die auf beiden Flachseiten der leitenden Schicht jeweils Kontaktflächen aufweisen, welche auf der einen Seite den jeweiligen Anschlusskontakten des IC-Bausteines zugeordnet sind und auf der anderen Seite zur Außenkontaktierung vorgesehen sind, wobei die Außenkontaktflächen und die zugehörigen Leiterbahnen mit einer weiteren elektrisch leitenden Schutzschicht beschichtet werden.

Das oben beschriebene Verfahren wird im Stand der Technik eingesetzt, um Endlosfilme von Trägerelementen für die Halterung und Kontaktierung der IC-Bausteine herzustellen. Hierbei sieht der Herstellungsprozess derartiger Trägerelemente gemäß dem Stand der Technik vor, daß ein mit einer seitlichen Perforierung versehener elektrisch nicht leitendes Kunststoffband mit einem elektrisch leitenden Material, vorzugsweise Kupfer, beschichtet wird. Das Kunststoffband besitzt an denjenigen Stellen, an denen das fertige Trägerelement mit dem IC-Baustein bestückt wird, Durchbrüche, vorzugsweise in Form von runden Durchgangslöchern, für jede einzelne zwischen IC-Baustein und Trägerelement herzustellende Kontaktierung. Das mit der Kupferbeschichtung versehene Kunststoffband wird danach einem fotogalvanischen Prozess unterzogen, bei dem die Kupferbeschichtung zunächst an ihrer dem Kunststoffband abgewandten Außenseite mit einem Fotolack beschichtet, der Fotolack danach entsprechend der zu ätzenden Leiterbahnen belichtet, entwickelt und gewaschen wird, wobei der Fotolack nur an den Stellen verbleibt, der für die Leiterbahnen vorgesehen ist. Der anschließende Ätzprozess, dem die Kupferschicht danach unterzogen wird, beseitigt die auf dem Kunststoffband vorhandene Kupferschicht bis auf die mit dem Fotolack beschichteten Bereiche, so daß sich nach dem abschließenden Entfernen des Fotolacks auf dem Kunststoffband das entsprechende gewünschte Muster aus Leiterbahnen und Kontaktflächen für eine fortlaufende Zahl von Trägerelementen ergibt.

Abschließend werden diese verbleibenden Kupferschichtbereiche in einem weiteren Beschichtungsprozess beispielsweise verzinnt und vergoldet, um sie gegen Korrosion und Oxydation zu schützen. Die auf dem Kunststoffband vorhandenen üblicherweise in Zweiergruppen nebeneinander angeordneten Trägerelemente werden anschließend mit den IC-Bausteinen bestückt und elektrisch verbunden, danach erfolgt die Vereinzelung der Trägerelemente durch Ausstanzen oder Ausschneiden aus dem Kunststoffbandmaterial.

Die aus dem Stand der Technik bekannten Trägerelemente, welche nach dem oben beschriebenen Verfahren hergestellt werden, haben den Nachteil, daß sie durch den Gesamtaufbau von Kunststoffband, Leiterbahnen, IC-Baustein und über dem IC-Baustein aufgebrachtem sogenannten Vergusshügel, der zum Schutz der empfindlichen Anschlüsse des IC-Bausteines dient, im Hinblick auf die Gesamtdicke der mit den bestückten Trägerelementen ausgestatteten Datenträgerkarten eine nicht unbeträchtliche Dicke besitzen.

Ein Verfahren zur Herstellung dünner Trägerelemente ist in EP 0 529 097 A offenbart.

Zukünftige neue Anforderungen an die Flexibilität von Datenträgerkarten beispielsweise in Form von Chipkarten werden in nächster Zukunft dazu führen, die Dicke der auf den Chipkarten angeordneten elektronischen Bauelemente und deren Zubehör möglichst immer geringer werden zu lassen. Darüber hinaus verlangt der zukünftige Einsatz große Stückzahlen von Chipkarten nach einer Vereinfachung der Herstellung sowohl der Chipkarten als auch der zugeordneten Bauteile und somit einer Verbilligung der Herstellung.

Aufgabe der vorliegenden Erfindung ist es daher, ein Verfahren der oben beschriebenen gattungsgemäßen Art vorzustellen, durch das ein Trägerelement für einen zum Einbau in eine Datenträgerkarte vorgesehenen IC-Baustein einfach und kostengünstig unter Verringerung der Baudicke der Bauteileinheit IC-Baustein / Trägerelement hergestellt werden kann.

Diese Aufgabe wird zusammen mit den gattungsbildenden Merkmalen durch die verfahrenstechnische Lehre des Anspruches 1 gelöst. Die aufeinanderfolgenden Verfahrensschritte sehen hierbei vor, daß in einem ersten Schritt die elektrisch leitende Schicht in einer entsprechenden Dicke auf einer Flachseite an den für die Anschlusskontaktierung des IC-Bausteins vorgesehenen Kontaktflächenstellen mit einem flüssigen oder pastösen aushärtbaren Abdeckmaterial beschichtet wird. Anschließend werden die verbleibenden unbeschichteten Oberflächenbereiche der gleichen Flachseite mit einem flüssigen oder pastösen, aushärtbaren und nichtleitenden Material beschichtet. Die so einseitig beschichtete elektrisch leitende Schicht wird anschließend in aus dem Stand der Technik bekannter Weise fotochemisch behandelt, wobei aus der elektrisch leitenden Schicht die Leiterbahnen und Kontaktflächen ausgeätzt und mit weiteren elektrisch leitenden Schutzschichten, beispielsweise einer Verzinnung und einer Vergoldung, versehen werden. In einem abschließenden erfindungsgemäßen Verfahrensschritt wird das einseitig aufgebrachte Abdeckmaterial entfernt, so daß die auf dieser Seite für die Anschlusskontaktierung vorgesehenen Kontaktflächenstellen für eine Bestückung mit dem IC-Baustein freiliegen.

Durch das erfindungsgemäße Verfahren wird ein Trägerelement erzeugt, bei dem die sonst übliche Trägerfolie für die elektrisch leitende Schicht vollständig fehlt. Dies führt trotz geringfügig größerer Dicke der elektrisch leitenden Schicht durch eine entsprechende Materialzusammensetzung der vorzugsweise verwendeten Kupferfolie zu einer Verringerung der Höhe der Baueinheit aus IC-Baustein und Trägerelement. Die mechanische Festigkeit der Baueinheit wird im wesentlichen durch den oben erwähnten Vergusshügel erzielt, der nach dem Aufsetzen des IC-Bausteines auf das Trägerelement den gesamten Baustein überdeckt.

In den Unteransprüchen sind zusätzlich besondere Ausgestaltungen des erfindungsgemäßen Verfahrens anhand der dort geschilderten vorteilhaften Merkmale ausgeführt.

Als verfahrenstechnisch besonders vorteilhaft hat sich dabei erwiesen, die elektrisch leitende Schicht im Siebdruckverfahren mit einem Stopplack zu beschichten, da das Siebdruckverfahren für eine derartige Beschichtung technisch ausgereift und kostengünstig ist.

Darüber hinaus kann das anschließend aufgetragene nichtleitende Material ein Phenolharz mit Klebeeigenschaften sein, die es ermöglichen, nach dem Entfernen des Stopplackes das Phenolharz zur Festlegung des IC-Bausteines auf derjenigen Seite des Trägerelementes, auf der die Konktaktflächen, welche den jeweiligen Anschlusskontakten des IC-Bausteines zugeordnet sind, liegen, zu verwenden. Durch die speziellen Eigenschaften des Phenolharzes wird ein Verfahrensschritt bei der Produktion der Baueinheit IC-Baustein und Trägerelement überflüssig, der bislang vorsah, nach Abschluss des Ätzprozesses für die Leiterbahnen an der der Leiterbahnseite abgewandten Rückseite der Kunststoffträgerschicht eine Klebebeschichtung für den IC-Baustein in einem gesonderten Prozess aufzubringen. Die Einsparung dieses Verfahrensschrittes senkt somit die Gesamtherstellungskosten und vereinfacht u. U. die Fertigung der mit dem IC-Baustein und Trägerelement ausgestatteten Chipkarten dadurch, daß bereits fertig kleberbeschichtete Trägerelemente vom Trägerelementhersteller bereitgestellt werden können. Außerdem führt der Wegfall einer gesonderten Klebeschicht zu einer weiteren Reduzierung der Gesamtbauteildicke.

Bezüglich des Abdeckmaterials kann es zweckmäßig sein, wenn dieses sich im Rahmen des abschließenden Verfahrensschrittes durch Wassereinsatz wieder von der elektrisch leitenden Schicht entfernen läßt oder unter Einsatz von UV-Licht zerfällt.

Es hat sich zudem als vorteilhaft für die Herstellung des Trägerelementes sowohl im Hinblick auf die Stabilität als auch auf den erforderlichen Materialeinsatz erwiesen, wenn die Schichtdicke der leitenden Schicht im Bereich von 50 bis 70 µm liegt.

Im folgenden wird das erfindungsgemäße Verfahren anhand der beigefügten Zeichnungen 1 bis 8 in den einzelnen Verfahrensschritten näher erläutert, wobei die Zeichnungen 1 bis 6 eine vergrößerte Schnittdarstellung durch ein Trägerelement mit angefügtem Transportbereich (Traktorlochung) zeigen.

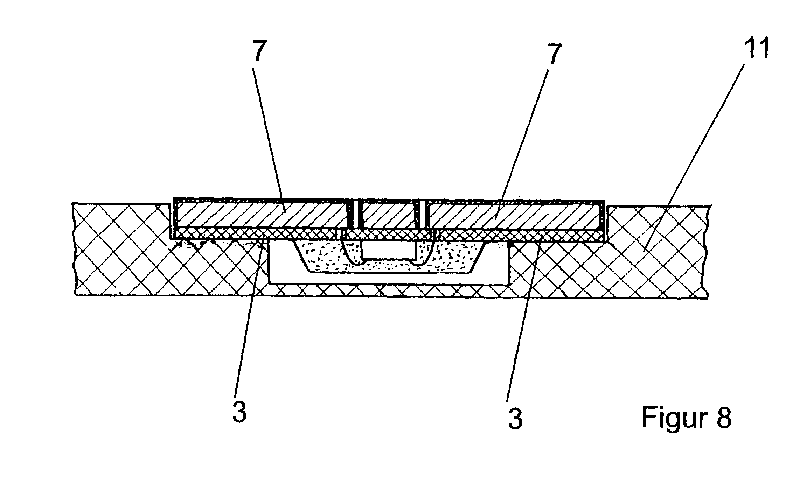

Die Figur 8 zeigt ein erfindungsgemäß hergestelltes Trägerelement eingebaut in eine Datenträgerkarte.

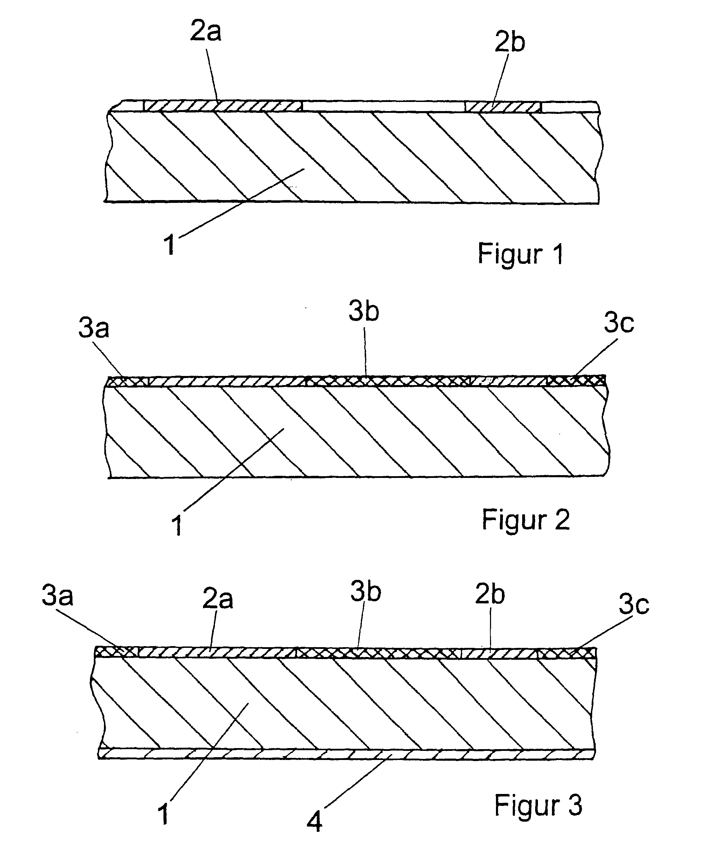

Die Figur 1 stellt hierbei den Zustand des Trägerelementes nach Ablauf des ersten Verfahrensschrittes dar, bei dem auf eine elektrisch leitende Schicht 1, vorzugsweise aus einer Kupferlegierung eine Abdeckmaterialschicht 2 aufgetragen wurde, wobei die Auftragsstellen des Abdeckmaterials 2a und 2b mit den für die Anschlusskontaktierung vorgesehenen Kontaktflächenstellen 2a und der sogenannten Traktorlochung 2b übereinstimmen. Die Traktoriochung ist zum Transport der fertigen Trägerelemente im Rahmen der Bestückung mit den IC-Bausteinen notwendig. Das Abdeckmaterial sollte zum leichteren Auftrag eine Viskosität im flüssigen oder pastösen Bereich aufweisen.

Die Figur 2 zeigt das Trägerelement nach Durchführung des zweiten Verfahrensschrittes, in dessen Verlauf die verbleibenden unbeschichteten Oberflächenbereiche 3a, 3b, 3c der vorher mit dem Abdeckmaterial beschichteten Flachseite der Kupferschicht mit einem flüssigen oder pastösen, aushärtbaren und nichtleitenden Material, vorzugsweise einem plastifizierten Phenolharz 3 beschichtet werden. Die Beschichtung der Kupferfolie 1 erfolgt vorteilhafterweise im Siebdruckverfahren, so daß sich, wie dies die Figur 2 zeigt, nach Abschluss des zweiten Verfahrensschrittes eine einheitliche Beschichtungsfläche aus Abdeckmaterialbereichen 2a, 2b und Phenolharzbereichen 3a, 3b und 3c ergibt.

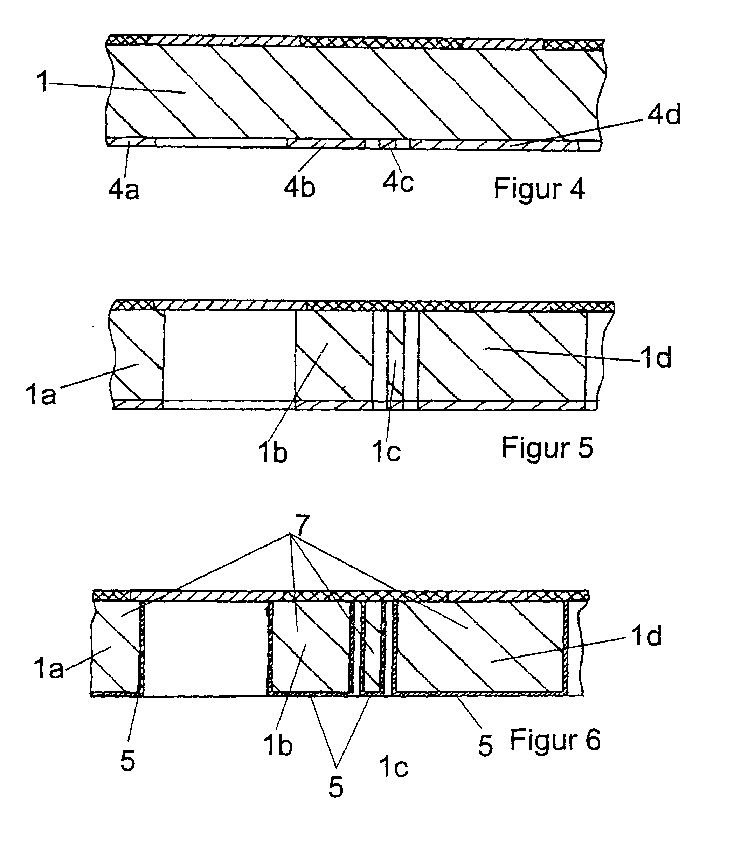

Anschließend wird aus der zusammenhängenden elektrisch leitenden Schicht (Kupferfolie) 1 das Layout der Leiterbahnen 7 ausgeätzt. Dies geschieht dadurch, daß zunächst entsprechend Figur 3 die Kupferfolie 1 an ihrer unbeschichteten Seite mit einer Fotolackschicht 4 versehen wird. Anschließend wird die Fotolackschicht 4 belichtet, entwickelt und gespült, wobei sich die in Figur 4 dargestellten Schichtbereiche der Fotolackschicht 4 ergeben, die denjenigen Bereichen entspricht, in denen später in der Kupferschicht 1 die Leiterbahnen 7 verbleiben sollen. Anschließend wird die Kupferfolie 1 an den Stellen, an der sie nicht mit der Fotolackschicht 4 beschichtet ist, weggeätzt, so daß sich Kupferschichtabschnitte 1 a, 1 b, 1 c und 1 d am Trägerelement entsprechend der Figur 5 ergeben.

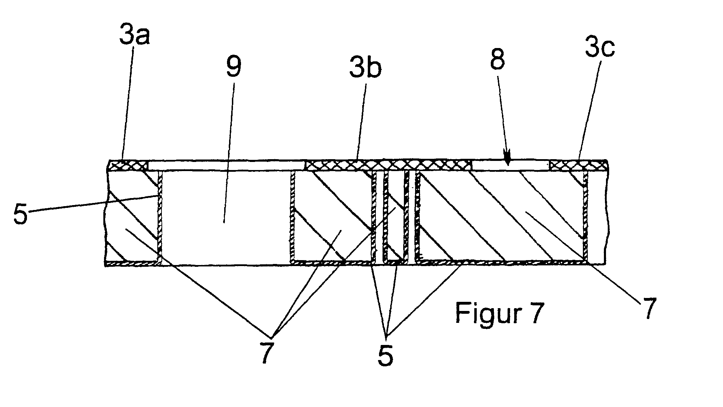

Anschließend wird in einem weiteren Verfahrensschritt der Fotolack entfernt und die entstandenen Leiterbahnen 7 mit einer Nickel- und Goldschicht 5 überzogen. An diesen Verfahrensschritt schließt sich die Entfernung des Abdeckmaterials 2 an den entsprechenden Stellen 2a und 2b an, so daß sich die in Figur 7 dargestellte Querschnittsgestaltung des Trägerelementes ergibt.

Soll die elektrisch leitende Schicht 1 beidseitig mit dem Ni/Au-Überzug versehen werden, ist der Verfahrensschritt des Entfernens des einseitig aufgetragene Abdeckmaterials 2 vor Durchführung der Verfahrensschritte des Ausätzens der Leiterbahnen 7 und Kontaktflächen aus der elektrisch leitenden Schicht 1 und der Beschichtung mit der weiteren elektrisch leitenden Schutzschicht 5 auszuführen.

Aus der Figur 7 ist ersichtlich, daß das Trägerelement im wesentlichen aus den Leiterbahnen 7 aus elektrisch leitendem Material, vorzugsweise einer Kupferlegierung besteht, wobei die Leiterbahnen auf der einen Seite mit einer weiteren elektrisch leitenden Schicht 5 wie beispielsweise Ni und Au zur Korrosions- und Oxidationsverhinderung der Kupferschicht versehen sind. An der nicht zur Oxidationsverhinderung der Kupferschicht behandelten Flachseite weist das Trägerelement isolierende Phenolharzbereiche 3a, 3b, 3c auf und dazwischen liegende Bereiche 8 als Kontaktflächen für die Verbindung zu den Anschlusskontakten des aufzubringenden IC-Bausteines als auch Bereiche 9, die als durchgehende Löcher das gesamte Trägerelement durchschneiden und als Traktorlochung dienen.

Aus der Figur 7 ergibt sich darüber hinaus, daß bei entsprechender Materialauswahl insbesondere die der Kontaktfläche 2b benachbarten Phenolharzbereiche 3b und 3c der Verklebung des IC-Bausteines mit dem Trägerelement dienen können, sofern das Phenolharz entsprechende Klebeeigenschaften besitzt.

In der Figur 8 ist das erfindungsgemäß hergestellte Trägerelement in eine Datenträgerkarte eingesetzt, wobei ersichtlich ist, daß das Trägerelement mittels der Klebeeigenschaften der Phenolharzschicht 3in der Karte gehalten wird, es entfällt somit eine seperate Klebeschicht zwischen der Phenolharzschicht und der Datenträgerkarte 11.

## Patentansprüche

1. Verfahren zur Herstellung eines Trägerelementes für einen zum Einbau in eine Datenträgerkarte vorgesehenen IC-Baustein, bei dem aus einer elektrisch leitenden Schicht in Form einer Metallfolie Leiterbahnen geätzt werden, die auf beiden Flachseiten des Trägerelementes jeweils Kontaktflächen aufweisen, welche auf der einen Seite den jeweiligen Anschlußkontakten des IC-Bausteinas zugeordnet sind und auf der anderen Seite zur Außenkontaktierung vorgesehen sind, **dadurch gekennzeichnet, daß**
- in einem ersten Verfahrensschritt die elektrisch leitende Schicht (1) auf einer Flachseite an den für die Anschlußkontaktierung vorgesehenen Kontaktflächenstellen (2b) mit einem flüssigen oder pastösen aushärtbaren Abdeckmaterial (2) beschichtet wird,
- anschließend die verbleibenden unbeschichteten Oberflächenbereiche (3a, 3b, 3c) der gleichen Flachseite mit einem flüssigen oder pastösen aushärtbaren nichtleitenden Material (3) beschichtet werden,
- in nächsten Verfahrensschritten aus der elektrisch leitenden Schicht (1) an ihrer unbeschichteten Seite die Leiterbahnen (7) und Kontaktflächen ausgeätzt und mit einer weiteren elektisch leitenden Schutzschicht (5) beschichtet werden und
- in einem abschließenden Verfahrensschritten das einseitig aufgetragene Abdeckmaterial (2) entfernt wird.

2. Verfahren zur Herstellung eines Trägerelementes nach Anspruch 1, **dadurch gekennzeichnet, daß** das nichtleitende Material (3) Phenolharz ist.

3. Verfahren zur Herstellung eines Trägerelementes nach Anspruch 1, **dadurch gekennzeichnet, daß** das nichtleitende Material (3) Klebeeigenschaften aufweist.

4. Verfahren zur Herstellung eines Trägerelementes nach Anspruch 1, **dadurch gekennzeichnet, daß** die elektrisch leitende Schicht (1) im Siebdruckverfahren mit dem Abdeckmaterial (2) beschichtet wird.

5. Verfahren zur Herstellung eines Trägerelementes nach Anspruch 3, **dadurch gekennzeichnet, daß** das nichtleitende, klebende Material (3) nach Entfernen des Abdeckmaterials (2) zur Festlegung des IC-Bausteines auf derjenigen Seite des Trägerelementes, auf der die Kontaktflächen (2b), welche den jeweiligen Anschlußkontakten des IC-Bausteines zugeordnet sind, liegen, vorgesehen ist.

6. Verfahren zur Herstellung eines Trägerelementes nach Anspruch 1, **dadurch gekennzeichnet, daß** die leitende Schicht (1) aus Kupfer mit einer Schichtdicke von 50 bis 70 µm besteht.

7. Verfahren zur Herstellung eines Trägerelementes nach einem der Ansprüche 1 bis 6, **dadurch gekennzeichnet, daß** der Verfahrensschritt des Entfernens des einseitig aufgetragene Abdeckmaterials (2) vor Durchführung der Verfahrensschritte des Ausätzens der Leiterbahnen (7) und Kontaktflächen aus der elektrisch leitenden Schicht (1) und der Beschichtung mit der weiteren elektrisch leitenden Schutzschicht (5) durchgeführt wird.

## Claims

1. Method for producing a support element for an IC component which is to be included in a data carrier card, wherein conductor strips which have contact surfaces on both flat sides of the support element in each case are etched out of a conductive layer in the form of a metal foil, said contact surfaces being assigned on the one side to the respective connecting contacts of the IC component and serving on the other side as an external contact, **characterized in that**
- in a first method step the electrically conductive layer (1) is coated with a liquid or pasty curable coating material (2) on one flat side on the contact surface points (2b) intended for making the connecting contact,
- the remaining uncoated surface regions (3a, 3b, 3c) of the same flat side are then coated with a liquid or pasty curable non-conductive material (3),
- in subsequent steps of the method, the conductor strips (7) and contact surfaces are etched out of the electrically conductive layer (1) on its uncoated side and are coated with the additional electrically conductive protective layer (5), and
- in a final method step, the coating material (2) which has been applied only to one side is removed.

2. Method for producing a support element according to Claim 1, **characterized in that** the non-conductive material (3) is phenolic resin.

3. Method for producing a support element according to Claim 1, **characterized in that** the non-conductive material (3) has adhesive properties.

4. Method for producing a support element according to Claim 1, **characterized in that** the electrically conductive layer (1) is coated with the coating material (2) using the screen printing technique.

5. Method for producing a support element according to Claim 3, **characterized in that**, after removal of the coating material (2), the non-conductive adhesive material (3) is provided for fixing the IC component on the side of the support element on which the contact surfaces (2b) that are assigned to the respective connecting contacts of the IC component lie.

6. Method for producing a support element according to Claim 1, **characterized in that** the conductive layer (1) is composed of copper with a layer thickness of 50 to 70 µm.

7. Method for producing a support element according to one of Claims 1 to 6, **characterized in that** the method step of removal of the coating material (2) applied only to one side is performed before the method steps of etching the conductor strips (7) and contact surfaces out of the electrically conductive layer (1) and coating with the additional electrically conductive layer (5) are performed.

## Revendications

1. Procédé pour la fabrication d'un élément de support pour un module IC, prévu pour être incorporé dans une carte de support de données, dans lequel des pistes conductrices sont formées par gravure dans une couche conductrice en forme de feuille métallique, lesquelles présentent, chacune, sur les deux faces de l'élément de support, des surfaces de contact qui, sur une face, sont associées au contact de connexion correspondant du module IC et, sur l'autre face, sont prévues pour un contact vers l'extérieur, **caractérisé en ce que**,
- lors d'une première étape du procédé, la couche conductrice de l'électricité (1) est revêtue, sur une face plane, dans les positions de contact (2b) prévues pour le contact de connexion, d'une matière de recouvrement durcissable, liquide ou pâteuse (2),
- les sections de surface restantes, non revêtues (3a, 3b, 3c), de la même surface plane, sont ensuite revêtues d'une matière durcissable, liquide ou pâteuse, non conductrice (3),
- lors de l'étape suivante du procédé, les pistes conductrices (7) et les surfaces de contact sont formées par gravure dans la couche conductrice d'électricité (1), sur le côté non revêtu de celle-ci, et sont revêtues d'un nouvelle couche de protection (5) conduisant l'électricité,
- lors d'une étape finale du procédé, la matière de recouvrement (2), appliquée d'un côté, est éliminée.

2. Procédé pour la fabrication d'un élément de support selon la revendication 1, **caractérisé en ce que** la matière non conductrice (3) est de la résine phénolique.

3. Procédé pour la fabrication d'un élément de support selon la revendication 1, **caractérisé en ce que** la matière non conductrice (3) présente des propriétés adhésives.

4. Procédé pour la fabrication d'un élément de support selon la revendication 1, **caractérisé en ce que** la couche conductrice d'électricité (1) est revêtue de la matière de recouvrement (2) par sérigraphie.

5. Procédé pour la fabrication d'un élément de support selon la revendication 3, **caractérisé en ce que** la matière adhésive, non conductrice (3), après l'élimination de la matière de recouvrement (2), est prévue pour la fixation du module IC sur le côté de l'élément de support, sur lequel se trouvent les surfaces de contact (2b), qui sont respectivement associées aux contacts de connexion dudit module IC.

6. Procédé pour la fabrication d'un élément de support selon la revendication 1, **caractérisé en ce que** la couche conductrice (1) est en cuivre et présente une épaisseur de couche de 50 à 70 µm.

7. Procédé pour la fabrication d'un élément de support selon l'une des revendications 1 à 6, **caractérisé en ce que** l'étape du procédé consistant à éliminer la matière de recouvrement (2), appliquée d'un côté, est effectuée avant l'exécution des étapes du procédé consistant à graver les pistes conductrices (7) et les surfaces de contact sur la couche conductrice d'électricité (1), ainsi qu'à appliquer l'autre couche protectrice, conductrice d'électricité (5).
